# EUROPÄISCHE PATENTSCHRIFT

(11) **EP 3 339 185 B1**
(45) Veröffentlichungstag und Bekanntmachung des Hinweises auf die Patenterteilung: **15.05.2019**
(21) Anmeldenummer: 16205978.6
(22) Anmeldetag: 21.12.2016
(51) Int. Cl.: B64D 45/02, B64D 35/00, H01T 7/00, H01T 4/08, H01T 4/10, B64C 39/02, B64D 27/24

(54) **LUFTFAHRZEUGANTRIEBSVORRICHTUNG SOWIE DAMIT VERSEHENES LUFTFAHRZEUG**
AIRCRAFT DRIVE DEVICE AND AIRCRAFT WITH SAME
DISPOSITIF D'ENTRAÎNEMENT D'UN AÉRONEF ET AÉRONEF EN ÉTANT ÉQUIPÉ

(43) Veröffentlichungstag der Anmeldung: 27.06.2018
(73) Patentinhaber: Airbus Defence and Space GmbH, 82024 Taufkirchen (DE)
(72) Erfinder: Steinwandel, Jürgen, 88690 Uhldingen-Mühlhofen (DE); HOFMANN, Michael, 85579 Neubiberg (DE); JUDAS, Michael, 80331 München (DE)
(74) Vertreter: Kastel, Stefan

(56) Entgegenhaltungen:
- WO-A1-84/01673
- DE-A1-102004 004 480
- US-A1- 2007 114 797
- US-A1- 2011 284 688

## Beschreibung

Die Erfindung betrifft eine Luftfahrzeugantriebsvorrichtung zum Erzeugen eines Vortriebs und/oder Auftriebs eines Luftfahrzeuges, die eine Drehwelle aufweist, welche aus einem Gehäuse herausragt. Außerdem betrifft die Erfindung ein damit versehenes Luftfahrzeug.

Beispiele für derartige Luftfahrzeugantriebsvorrichtungen sind in der DE 10 2013 109 392 A1 oder der DE 10 2010 021 024 B1 offenbart.

Flugzeuge mit elektrisch angetriebenen Propellern sind derzeit nicht nur Gegenstand theoretischer Überlegungen, sondern stehen am Beginn konkreter Entwicklungen für unterschiedliche Anwendungsfälle, siehe die zuvor erwähnten Druckschriften sowie die DE 10 2013 101 602 A1 und die DE 10 2006 056 356 A1.

Aus der DE 10 2004 004 480 A1 ist ein Elektrotriebwerk für den Antrieb koaxialer Wellen von Drehmechanismen bekannt, wobei das Elektrotriebwerk beispielsweise zum Antrieb eines Hubschraubers mit zwei Propellern auf einer geometrischen Achse eingesetzt werden kann.

Aus der WO 84/01673 A1 ist ein Überspannungsschutz für eine Windturbine oder ein drehbare Antenne bekannt, wobei an einem Eingang eines Lagergehäuses ein schmaler Spalt gebildet ist, der als Überschlagszone für elektrische Überschläge zur Funkenentladung dient. Damit können an dem Windturbinenrotor oder der drehbaren Antenne anliegende Überspannungen durch Funkenentladung an dem Spalt auf das geerdete Lagergehäuse übertragen werden.

Aufgabe der Erfindung ist es eine Luftfahrzeugantriebsvorrichtung zum Erzeugen eines Vortriebs und/oder Auftriebs eines Luftfahrzeuges, die eine Drehwelle aufweist, welche aus einem Gehäuse herausragt, hinsichtlich der Betriebssicherheit unter unterschiedlichen Wetterbedingungen bei geringem konstruktivem Aufwand zu verbessern.

Zum Lösen dieser Aufgabe schafft die Erfindung eine Luftfahrzeugantriebsvorrichtung nach Anspruch 1.

Vorteilhafte Ausgestaltungen der Erfindung sind Gegenstand der Unteransprüche.

Weiter wird ein Luftfahrzeug mit einer solchen Luftfahrzeugantriebsvorrichtung angegeben.

Die Erfindung schafft gemäß einem Aspekt eine Luftfahrzeugantriebsvorrichtung zum Erzeugen eines Vortriebs und/oder Auftriebs eines Luftfahrzeuges, umfassend eine Drehwelle, ein Drehwellenlager, eine Drehwellenantriebsmaschine zum drehenden Antreiben der Drehwelle und ein Gehäuse, wobei das Drehwellenlager und die Drehwellenantriebsmaschine in einen Innenraum des Gehäuses angeordnet sind und die Drehwelle durch eine Gehäuseöffnung des Gehäuses nach außerhalb des Gehäuses ragt, wobei im Bereich der Gehäuseöffnung eine Überspannungsableitungseinrichtung angeordnet ist, die zum Ableiten einer auf der Drehwelle anliegenden Überspannung ausgebildet ist.

Gemäß der Erfindung ist vorgesehen, dass die Überspannungsableitungseinrichtung ein auf einem Potential, auf das hin die Ableitung erfolgen soll, z.B. auf Gehäusepotential oder auf Masse, liegendes stationäres Elektrodenelement und ein auf Drehwellenpotential liegendes drehbares Elektrodenelement aufweist, wobei die Elektrodenelemente zur kontaktfreien Spannungsüberleitung von Überspannungen durch einen Spalt beabstandet sind.

Gemäß einer ersten Alternative der Erfindung ist vorgesehen, dass wenigstens eines der Elektrodenelementen einen ersten Ring und einen zweiten Ring aufweist, zwischen denen das andere Elektrodenelement aufgenommen ist.

Gemäß einer zweiten Alternative der Erfindung ist vorgesehen, dass die Elektrodenelemente mit felderhöhenden Strukturen mit Spitzen aus leitfähigem Material versehen sind.

Es ist bevorzugt, dass zumindest ein Bereich der Drehwelle auf einem elektrischen Drehwellenpotential liegt und zumindest ein Bereich des Gehäuses auf einem elektrischen Gehäusepotential liegt und dass die Überspannungsableitungseinrichtung zum Ableiten einer Überspannung von dem Drehwellenpotential auf das Gehäusepotential ausgebildet ist. Alternativ kann die Überspannungsableitungseinrichtung die Überspannung auch auf andere Potentiale am Luftfahrzeug, z.B. auf Masse oder das Potential einer elektrischen Entlade- oder Verteileinrichtung, ableiten.

Es ist bevorzugt, dass die Drehwellenantriebsmaschine eine elektrische Maschine, insbesondere ein Elektromotor mit Rotor und Stator, ist.

Es ist bevorzugt, dass die Luftfahrzeugantriebsvorrichtung einen elektrisch angetriebenen Propeller aufweist.

Es ist bevorzugt, dass ein Propeller an dem aus dem Gehäuse herausragenden Bereich der Drehwelle angeordnet ist.

Es ist bevorzugt, dass ein erstes Drehwellenlager und ein zweites Drehwellenlager vorgesehen sind.

Es ist bevorzugt, dass das Gehäuse zum Schaffen eines Blitzschutzes für die Drehwellenantriebsmaschine selbst ausgebildet ist.

Es ist bevorzugt, dass das Gehäuse einen Faraday'schen Käfig schafft.

Es ist bevorzugt, dass wenigstens eines der Elektrodenelemente ringförmig ausgebildet ist.

Es ist bevorzugt, dass die Elektrodenelemente einander gegenüberliegende im Wesentlichen parallele Elektrodenflächen aufweisen, zwischen denen der Spalt gebildet ist.

Es ist bevorzugt, dass wenigstens eines der Elektrodenelemente ein Lichtbogenzündelement zum Zünden eines Plasmakanals zwecks Überleitung der Überspannung aufweist.

Es ist bevorzugt, dass wenigstens eines der Elektrodenelemente mit einer Beschichtung versehen ist, in der Spitzen aus leitfähigen Partikeln und/oder polarisierenden Partikeln vorgesehen sind.

Es ist bevorzugt, dass der Spalt den kleinsten Abstand zwischen dem Drehwellenpotential und dem Gehäusepotential darstellt.

Es ist bevorzugt, dass der Spalt einen Spaltabstand im Bereich von 0, 1 µm bis 10 mm, vorzugsweise im Bereich von 0,01 mm bis 5 mm, hat.

Es ist bevorzugt, dass das Drehwellenlager ein stationäres Lagerelement und ein drehbares Lagerelement und eine elektrische Isolation zum elektrischen Isolieren des stationären Lagerelements vom drehbaren Lagerelement hat.

Es ist bevorzugt, dass zumindest ein Bereich der Drehwelle und/oder des Gehäuses mit einer Blitzschutzbeschichtung versehen ist.

Es ist bevorzugt, dass die Blitzschutzbeschichtung eine elektrisch leitfähige Schicht aufweist.

Es ist bevorzugt, dass die Blitzschutzbeschichtung mit einem elektrisch leitfähigen Gitter versehen ist.

Es ist bevorzugt, dass die Blitzschutzbeschichtung mit elektrisch polarisierbaren Partikeln versehen ist.

Es ist bevorzugt, dass die Blitzschutzbeschichtung mit mit Spitzen versehenen elektrisch leitfähigen Partikeln versehen ist.

Es ist bevorzugt, dass die Blitzschutzbeschichtung eine Beschichtung mit elektrisch polarisierbaren Partikeln in einer dielektrischen Matrix ist.

Es ist bevorzugt, dass die Blitzschutzbeschichtung eine Beschichtung mit mit Spitzen versehenen elektrisch leitfähigen Partikeln in einer dielektrischen Matrix ist.

Es ist bevorzugt, dass die Blitzschutzbeschichtung eine Beschichtung mit Zündelementen zum Zünden eines Lichtbogens ist.

Es ist bevorzugt, dass die Überspannungsableiteinrichtung ein Windabweiserelement zum Schutz des Lichtbogens aufweist.

Es ist bevorzugt, dass die Überspannungsableiteinrichtung die Ableitung einer Überspannung zwischen der sich drehenden Drehwelle und einem feststehenden Teil ermöglicht.

Es ist bevorzugt, dass die Überspannungsableiteinrichtung so ausgebildet ist, dass die Ableitung der Überspannung berührungslos durch einen Überschlag und Lichtbogen erfolgt.

Es ist bevorzugt, dass die Überspannungsableiteinrichtung eine feldüberhöhende Geometrie aufweist, so dass der Überschlag an dieser dafür vorgesehenen Stelle bevorzugt erfolgt.

Es ist bevorzugt, dass die Überspannungsableiteinrichtung mit einer feldüberhöhenden Beschichtung versehen ist, so dass der Überschlag an dieser dafür vorgesehenen Stelle bevorzugt erfolgt.

Soweit in der hiesigen Offenbarung, insbesondere den Ansprüchen eines der Worte "ein", "eine" oder "einer" verwendet ist, so ist damit in der Regel der unbestimmte Artikel und nicht ein Zahlwort gemeint; d.h. es können ein einzelnes der so bezeichneten Elemente oder mehrere dieser Elemente vorhanden sein.

Einige Vorteile und Besonderheiten von bevorzugten Ausgestaltungen der Erfindungen werden im Folgenden näher erläutert.

Ein besonders bevorzugter Aspekt der Erfindung betrifft einen Blitzschutz für elektrisch angetriebene Propeller.

Eine bevorzugte Ausgestaltung der Erfindung betrifft eine Luftfahrzeugantriebsvorrichtung mit einem elektrisch angetriebenen Propeller. Diese kann zum Vortrieb und/oder zum Auftrieb für das Luftfahrzeug dienen. Das Luftfahrzeug kann z.B. ein Flugzeug mit Auftriebstragflächen oder auch ein Drehflügler wie z.B. ein Hubschrauber oder ein Quadcopter (wobei hierunter auch Bauarten mit mehr oder weniger als vier Rotoren fallen sollen) sein.

Wie sich aus dem eingangs erwähnten Stand der Technik ergibt, sind Luftfahrzeuge, wie z.B. Flugzeuge, mit elektrisch angetriebenen Propellern derzeit nicht nur Gegenstand theoretischer Überlegungen, sondern stehen am Beginn konkreter Entwicklungen für unterschiedliche Anwendungsfälle.

Ein wichtiges Thema in der Luftfahrt ist der Schutz von Mensch und Technik vor den Folgen von Blitzeinschlägen in der Luft. Das Risiko eines Blitzschlages für ein Luftfahrzeug, wie z.B. Flugzeug, wird sich nicht verhindern lassen, also sollten entsprechende technische Maßnahmen ergriffen werden, um bei Auftreten eines Blitzschlags Schäden von Mensch und Technik abzuwenden.

Luftfahrzeuge, wie Flugzeuge, haben heute entweder eine metallische Außenhülle oder ein entsprechend eingearbeitetes leitfähiges Gewebe, z. B. aus Kupfer, um einen Faraday'schen Käfig zu realisieren, so dass die Bereiche innerhalb des Käfigs vor den Folgen eines Blitzschlags geschützt sind. Entsprechende Techniken werden auch bei dem Luftfahrzeug gemäß dem einen Aspekt der hier vorliegenden Erfindung verwendet.

Bevorzugt befindet sich eine elektrische Maschine, die einen Propeller antreibt, in einem umgebenden Gehäuse, um eine aerodynamisch vorteilhafte Ausgestaltung des Antriebs zu realisieren. Über dieses Gehäuse lässt sich mit den bekannten Maßnahmen ein Blitzschutz für die elektrische Maschine selbst realisieren.

Bei Luftfahrzeugantriebsvorrichtungen mit Propellern kann allerdings die im Freien angeordnete Position des Propellers und dessen Verbindung über die Antriebswelle mit der Drehwelle, beispielsweise dem Rotor der elektrischen Maschine, problematisch sein. Schlägt nun ein Blitz in den Propeller oder den vorderen Teil der Rotorwelle ein, so wird über die Rotorwelle auch der Rotor der elektrischen Maschine auf das elektrische Potential des Blitzes gehoben. Da der Abstand zwischen dem Rotor und dem (auf Massepotential liegenden) Stator prinzipbedingt möglichst klein gehalten werden sollte, um eine gute magnetische Koppelung zu erreichen, kommt es hier durch die hohe vom Blitz verursachte Spannungsdifferenz zu Überschlägen und vielfältigen Schädigungen, z. B. Zerstörung der Wicklungsisolation, Beschädigung von Magnetmaterial, Beschädigung von Oberflächen durch Aufschmelzen, ...

Eine weitere Schwachstelle stellen mechanische Lager der Rotorwelle dar, da auch hier, bedingt durch die hohe Spannungsdifferenz und die kleinen Abstände, bevorzugt Überschläge passieren. Hier führt dies z.B. zu Zersetzung des Schmiermittels, zu Beschädigungen der Lager-Laufflächen, zu Verschweißungen etc..

Weitere Schäden an einer nachgeschalteten Leistungselektronik und im Bordnetz des Flugzeugs sind sehr wahrscheinlich.

Während eine Isolation der Lager theoretisch mit entsprechendem Aufwand unter Umständen zu realisieren wäre, ist dies für die Konstellation Rotor - Stator technisch sinnvoll nicht möglich.

Mit besonders bevorzugten Ausgestaltungen der Erfindung ist es möglich, einen wartungsfreien Schutz der elektrischen Maschine und der nachfolgenden Komponenten vor den Folgen eines Blitzschlags in die Rotorwelle zu realisieren, ohne die Maschine selbst zu verändern.

Vorzugsweise ist vorgesehen, dass im Eintrittsbereich der Rotorwelle (oder einer sonstigen vorstehenden Drehwelle) in das umgebende Gehäuse ein Element angeordnet wird, welches die Überspannung bereits an dieser Stelle auf das Gehäusepotential ableitet und so die nachfolgende Maschine und weitere Komponenten schützt.

Vorzugsweise ist als weitere Maßnahme in Kombination hierzu eine BlitzschutzBeschichtung vorgesehen, die im Fall eines Blitzeinschlags durch Ablation einen Teil der Blitzenergie absorbiert und somit die verbleibende abzuleitende Energie verringert. Beispiele für entsprechende Beschichtungen sind z.B. in der DE 10 2006 046 002 A1 oder der DE 10 2011 112 518 A1 beschrieben, die Beschichtungen offenbaren, in denen Spitzen aus leitfähigen Partikeln und/oder polarisierenden Partikeln vorgesehen sind.

Vorzugsweise erfolgt eine berührungslose Darstellung dieser Überspannungsableitungs-Funktion, die ohne verschleißende Elemente wie Schleifkontakte auskommen soll, durch zwei einander zugeordnete, leitfähige Elemente (hier aufgrund deren Funktion Elektrodenelemente) genannt, von denen eines drehend und leitfähig mit der Rotorwelle und das andere feststehend und leitfähig mit dem Gehäuse und der umgebenden Struktur verbunden ist, in welche der Blitzstrom abgeleitet werden soll. Die Elemente sind so zueinander positioniert, dass sie sich bis auf einen sehr kleinen Luftspalt nahezu berühren und somit einen bevorzugten Ort des Überschlags des Blitzes von der Rotorwelle auf die Struktur darstellen.

Ein weiterer Aspekt bevorzugter Ausführungsformen der Erfindung ist die Ausgestaltung der Bereiche, zwischen denen der Überschlag nun bevorzugt stattfindet, derart, dass es hier zu einer Feldüberhöhung kommt, die ein Zünden des Lichtbogens bevorzugt an dieser Stelle herbeiführt. Auch eine in der DE 10 2006 046 002 A1 genannte nanostrukturierte Variante zur Erhöhung der lokalen Feldstärke ist möglich.

Vorzugsweise unterstützt eine realisierte Isolation der Rotorwellenlager gegenüber des Gehäuses / der Struktur einen Überschlag an der dafür vorgesehenen Stelle.

Vorzugsweise sind die einander zugeordneten Elektrodenelemente so ausgestaltet, dass ein einmal brennender Lichtbogen, der infolge des Plasmakanals einen sehr geringen Spannungsabfall aufweist, möglichst bis zum völligen Abklingen des Blitzstromes brennend gehalten wird, um wiederholte Überspannungsbelastungen der elektrischen Maschine infolge Unterbrechung und Neuzündens des Lichtbogens zu vermeiden. Dies kann z. B. durch Abschirmen des Bereichs gegen den anströmenden Fahrtwind geschehen, um ein Abkühlen des Lichtbogens zu vermeiden. Vorzugsweise ist ein Windabweiserelement zum Schutz Lichtbogens vorgesehen. Dies kann ein gesondert vorgesehenes Element oder ein Teil eines bereits vorhandenen Elements, z.B. an dem Gehäuse sein.

Vorzugsweise wird ein Faraday'scher Käfig, den das Gehäuse bildet, im Fall eines Blitzschlags über die elektrische Maschine und bis zum Ort der einander zugeordneten Elemente ausgedehnt.

Gemäß einem Aspekt schafft die Erfindung eine Vorrichtung, die die Ableitung einer Überspannung zwischen einer drehenden Rotorwelle und einem feststehenden Teil ermöglicht.

Gemäß einem weiteren Aspekt betrifft die Erfindung eine Vorrichtung, die diese Ableitung einer Überspannung berührungslos durch einen Überschlag und Lichtbogen realisiert.

Gemäß einem weiteren Aspekt betrifft die Erfindung eine Vorrichtung, die so gestaltet ist, dass sie eine feldüberhöhende Geometrie aufweist, so dass der Überschlag an dieser dafür vorgesehenen Stelle bevorzugt erfolgt.

Gemäß einem weiteren Aspekt betrifft die Erfindung eine Vorrichtung, die mit einer feldüberhöhenden Beschichtung versehen ist, so dass der Überschlag an dieser dafür vorgesehenen Stelle bevorzugt erfolgt.

Gemäß einem weiteren Aspekt betrifft die Erfindung eine Vorrichtung, die in der Lage ist, den bei einem Blitzschlag und einem Überschlag den zwischen drehendem und feststehendem Teil fließenden Strom mindestens für die Dauer des Blitzschlages vollständig zu tragen, ohne dabei Schaden zu nehmen oder zumindest ihre Funktion zu verlieren.

Gemäß einem weiteren Aspekt betrifft die Erfindung eine Kombination mit einer Beschichtung oder anderen Maßnahme, die in der Lage ist, einen Teil der ankommenden Blitzenergie zu absorbieren, um die von der Vorrichtung abzuleitende Energie gegenüber der ursprünglichen Blitzenergie zu reduzieren.

Gemäß einem weiteren Aspekt betrifft die Erfindung eine Isolation der drehenden Lagerung hinter dieser Vorrichtung, die den drehenden Teil gegenüber dem feststehenden Teil isoliert und somit einen Überschlag im Bereich der Lagerung unwahrscheinlich macht.

Gemäß einem weiteren Aspekt betrifft die Erfindung eine Anordnung der drehenden und der feststehenden Elemente der Anordnung derart, dass ein Lichtbogen möglichst lange am Brennen gehalten wird, um wiederholte Überspannungsbelastungen zu vermeiden.

Wenngleich die Erfindung und deren Vorteile anhand bevorzugter Ausführungsformen von elektrischen Propellerantrieben beschrieben wird, so ist die Erfindung nicht darauf beschränkt, sondern auf alle Antriebe für Luftfahrzeuge anwendbar, bei denen sich eine Drehwelle aus einem schützenden Gehäuse heraus nach außen erstreckt und bei denen eine Erhöhung des elektrischen Potentials der Drehwelle insbesondere durch Blitzschutz im Inneren des Gehäuses zu Problemen oder Schäden führen könnte. Z.B. kann die Drehwellenantriebsmaschine eine Wärmekraftmaschine wie Kolbenmotor oder Wankelmotor aufweisen; wobei Überschläge an Lagern die oben erwähnten Probleme verursachen können.

Das Gehäuse kann ein gesondertes Antriebsgehäuse sein, das nur die Drehantriebsmaschine einhaust, es kann aber auch ein Gesamtgehäuse, z.B. Teil einer Struktur des Luftfahrzeuges, wie Rumpf oder Flügel oder Leitwerk sein, worin die Drehantriebsmaschine untergebracht sein kann.

Ausführungsbeispiele der Erfindung werden nachfolgend anhand der beigefügten Zeichnung näher erläutert. Darin zeigt:
- Fig. 1: eine schematische Darstellung einer Luftfahrzeugantriebsvorrichtung in nicht erfindungsgemäßer Ausbildung zu Erläuterungszwecken;
- Fig. 2: eine schematische Darstellung einer Luftfahrzeugantriebsvorrichtung gemäß einer Ausführungsform der Erfindung;
- Fig. 3a: eine vergrößerte Darstellung eines Details aus Fig. 2, die eine Überspannungsableitungseinrichtung der Luftfahrzeugantriebsvorrichtung gemäß einer Ausführungsform zeigt;
- Fig. 3b: eine Schnittdarstellung durch eine weitere Ausführungsform einer Überspannungsableitungseinrichtung;
- Fig. 4: eine schematische Darstellung einer weiteren Ausführungsform der Luftfahrzeugantriebsvorrichtung.

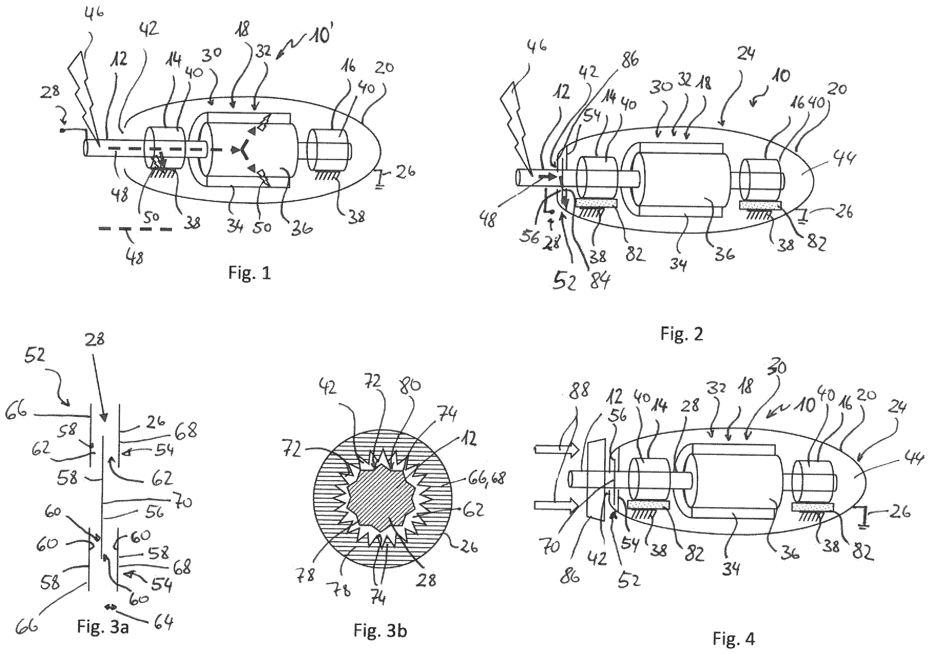

In den Fig. 1, 2 und 4 sind schematische Darstellungen einer Luftfahrzeugantriebsvorrichtung 10, 10' zum Erzeugen eines Vortriebs und/oder Auftriebs eines Luftfahrzeuges dargestellt. Fig. 1 zeigt dabei eine Luftfahrzeugantriebsvorrichtung 10' ohne erfindungsgemäße Ausbildung zu Erläuterungszwecken, wobei die Fig. 2 und 4 unterschiedliche Ausführungsformen einer erfindungsgemäßen Luftfahrzeugantriebsvorrichtung 10 darstellen.

Die Luftfahrzeugantriebsvorrichtung 10, 10' dient zum Erzeugen eines Vortriebs und/oder Auftriebs eines Luftfahrzeuges und umfasst eine Drehwelle 12, die durch ein erstes Drehwellenlager 14 und ein zweites Drehwellenlager 16 gelagert ist, eine Drehwellenantriebsmaschine 18 zum drehenden Antreiben der Drehwelle 12 und ein Gehäuse 20.

An der Drehwelle 12 ist insbesondere ein (nicht dargestellter) Propeller angeordnet, wobei hier unter Propeller auch z.B. ein Hauptrotor eines Drehflüglers gemeint sein kann.

Das Gehäuse 20 kann in nicht dargestellten Ausführungsbeispielen Teil einer Struktur (Rumpf, Flügel) des Luftfahrzeuges sein und/oder kann - wie in den dargestellten Ausführungsbeispielen - dazu dienen, eine aerodynamisch vorteilhafte Ausgestaltung des Antriebs des Luftfahrzeuges zu realisieren. Das Gehäuse 20 ist dazu ausgebildet, einen Blitzschutz für die Drehwellenantriebsmaschine 18 zu realisieren. Hierzu schafft das Gehäuse 20 insbesondere einen Faraday'schen Käfig 24. Hierzu kann das Gehäuse 20 selbst aus einem leitenden Material wie z.B. Metall gefertigt sein. Als besonders bevorzugte Ausgestaltung ist eine Hülle des Gehäuses 20 aus einem Verbundmaterial, wie z.B. CFK, ausgebildet, in dem eine (metallisch) leitende Schicht oder ein leitfähiges Gitter oder ein (metallisch) leitendes Netz oder ein Gewebe aus leitfähigem Material eingebettet ist. Vorzugsweise ist das Gehäuse 10 an seiner Oberfläche mit einer feldüberhöhenden Beschichtung versehen.

Das Gehäuse 20 liegt mit seinem Faraday'schen Käfig 24 insbesondere auf einem elektrischen Gehäusepotential 26; vorzugsweise sind entsprechend leitfähige Bereiche oder Schichten des Gehäuses 20 mit der elektrischen Masse des Luftfahrzeuges elektrisch verbunden.

Die Drehwelle 12 kann ebenfalls aus metallisch leitendem Material oder aus Verbundwerkstoffen, insbesondere aus CFK, gefertigt sein. Auch die Drehwelle 12 ist vorzugsweise mit wenigstens einer leitfähigen Schicht oder einer sich axial erstreckenden leitfähigen Bahn versehen, die auf einem elektrischen Drehwellenpotential 28 liegt.

Die Drehwellenantriebsmaschine 18 weist insbesondere eine elektrische Maschine 30 und mehr insbesondere einen Elektromotor 32 mit einem (in den Figuren aufgeschnitten dargestellten) Ständer 34, dessen elektrisches Potential ebenfalls mit Masse verbunden ist und somit auf Gehäusepotential 26 liegt, und einem Rotor 36 auf, wobei eine Rotorwelle des Rotors 36 mit der Drehwelle 12 verbunden ist oder diese bildet.

Die Drehwellenlager 14, 16 dienen zum Lagern der Drehwelle 12 und weisen jeweils ein stationäres Lagerelement 38 und ein drehbares Lagerelement 40 auf. Das stationäre Lagerelement 38 ist ortsfest verbunden und kann elektrisch auf Gehäusepotential 26 und/oder auf Masse liegen. Das drehbare Lagerelement 40 ist mit der Drehwelle 12 verbunden und kann auf Drehwellenpotential 28 liegen. Die Lagerelemente 38, 40 können z.B. Lagerschalen sein, zwischen denen Rollelemente laufen.

Da sich der Propeller im Außenraum außerhalb des Gehäuses 20 dreht, ist die Drehwelle 12 durch eine Gehäuseöffnung 42 vom Inneren 44 des Gehäuses 20 nach außen geführt und ragt so durch die Gehäuseöffnung 42 nach außen hinaus.

Auf dem hervorragenden Ende der Drehwelle 12 ist der Propeller aufgesetzt. Beispielsweise schließt die Drehwelle 12 nach außen hin mit einer Rotornase (nicht dargestellt) ab.

Fig. 1 zeigt eine Luftfahrzeugantriebsvorrichtung 10' ohne erfindungsgemäße Maßnahmen. Schlägt hier ein Blitz 46 in den Propeller oder das vorstehende Ende der Drehwelle 12 ein, so wird über die Drehwelle 12 - Rotorwelle - auch der Rotor 36 der elektrischen Maschine 30 auf das elektrische Potential des Blitzes 46 gehoben. Mit einer gestrichelten Linie ist in den Fig. 1 und 2 der jeweilige Stromverlauf 48 im Falle eines Blitzeinschlages dargestellt. Da der Abstand zwischen dem Rotor 36 und dem auf Massepotential liegenden Stator 34 möglichst klein gehalten werden sollte, um eine gute magnetische Kopplung zu erreichen, kann es hier durch die hohe vom Blitz 46 verursachte Spannungsdifferenz zu Überschlägen kommen, die vielfältige Schädigungen verursachen können, wie z.B. Zerstörung einer Wicklungsisolation, Beschädigungen von Magnetmaterial, Beschädigungen von Oberflächen durch Aufschmelzen usw. Weitere Überschläge 50 können zwischen den Lagerelementen 38, 40 der Drehwellenlager 14, 16, insbesondere des ersten Drehwellenlagers 14, welches sich zwischen der Gehäuseöffnung 42 und der elektrischen Maschine 30 befindet, entstehen. Die Überschläge 50 zwischen den Lagerelementen 38, 40 können zu Zersetzung eines Schmiermittels, zu Beschädigungen von Lager-Laufflächen oder zu Materialverschweißungen usw. führen.

Um diese Probleme zu vermeiden ist bei der Luftfahrzeugantriebsvorrichtung 10 in erfindungsgemäßer Ausbildung gemäß den Fig. 2 und 4 eine Überspannungsableitungseinrichtung 52 im Bereich der Gehäuseöffnung 42 angeordnet. Die Überspannungsableitungseinrichtung 52 ist zum Ableiten einer auf der Drehwelle 12 anliegenden Überspannung von dem Drehwellenpotential 28 auf das Gehäusepotential 26 und/oder auf Masse ausgebildet.

Mögliche Ausgestaltungen der Überspannungsableitungseinrichtung 52 sind in den Fig. 3a und 3b dargestellt.

Die Überspannungsableitungseinrichtung 52 weist ein stationäres Element und ein sich mit der Drehwelle 12 drehendes Element auf, zwischen denen die Überspannung abgeleitet wird. Dies erfolgt vorzugsweise kontaktlos mittels eines Lichtbogens. Aufgrund ihrer Funktion werden die Elemente der Überspannungsableitungseinrichtung 52 im Folgenden als Elektrodenelemente bezeichnet, wobei die Überspannung zwischen diesen Elektrodenelementen erfolgt.

Demnach weist in besonders bevorzugter Ausgestaltung die Überspannungsableitungseinrichtung 52 ein stationäres Elektrodenelement 54 auf, welches elektrisch mit Masse und/oder dem Gehäusepotential 26 verbunden ist. Weiter weist die Überspannungsableitungseinrichtung 52 ein drehendes Elektrodenelement 56 auf, das mit der Drehwelle 12 verbunden ist und elektrisch auf Drehwellenpotential 28 liegt. Die Elektrodenelemente 54, 56 weisen insbesondere Ringelektroden mit einer zugerichteten Elektrodenflächen 60 auf, die durch einen möglichst kleinen Spalt 62 beabstandet sind. Der Spaltabstand 64 zwischen den Elektrodenelementen 54, 56 ist vorzugsweise so gering, dass im Bereich der Elektrodenelemente 54, 56 der kleinste Abstand zwischen dem Gehäusepotential 26 und dem Drehwellenpotential 28 gebildet wird.

Bei der in Fig. 3a dargestellten Ausführungsform ist eines der Elektrodenelemente 56 zwischen zwei Bereichen des anderen Elektrodenelements 54 aufgenommen, wobei eines der Elektrodenelemente 54 zwei Ringelektroden 58 aufweist, zwischen denen die Ringelektrode 58 des anderen Elektrodenelements 56 aufgenommen ist.

In konkreter beispielhafter Ausgestaltung sind an der Gehäuseöffnung 42 ein äußerer Ring 66 und ein innerer Ring 68 aus oder mit elektrisch leitfähigem Material vorgesehen, zwischen denen ein auf die Drehwelle 12 aufgesetzter, hiervon radial abstehender Ring 70 eingreift.

Wie in Fig. 3b dargestellt, können die Elektrodenelemente 54, 56 mit felderhöhenden Strukturen 72 oder felderhöhenden Geometrien versehen sein. Spitzen aus leitfähigem Material sind hier vorgesehen (diese können auch durch ein Dielektrikum umgeben sein).

Mehr insbesondere ist die felderhöhende Struktur 72 in einer Beschichtung 78 der Elektrodenfläche 60 vorgesehen. Aus der DE 10 2006 046 002 A1 und der DE 10 2011 112 518 A1 sind Beschichtungen bekannt, in denen Spitzen aus leitfähigen Partikeln und/oder polarisierenden Partikeln vorgesehen sind. Die entsprechenden felderhöhenden Struktur 72 können an den Elektrodenflächen 60 der Ringelektroden 58 vorgesehen sein.

Bei der in Fig. 3b dargestellten Ausführung ist eine radial innere Fläche eines stationären Rings 66, 68, der die Drehwelle 12 mit dem geringen Spaltabstand 64 des Spaltes 62 umgibt, mit der felderhöhenden Struktur 72 versehen, wobei auch die Umfangsoberfläche 80 der Drehwelle 12 in diesem Bereich mit einer felderhöhenden Struktur 72 versehen ist.

Durch entsprechende Maßnahmen wird, siehe Fig. 2, bei Eintreffen des Blitzes 46 die durch den Blitz verursachte Überspannung auf dem Drehwellenpotential 28 über die Überspannungsableitungseinrichtung 52 im Bereich des Eintritts der Drehwelle 12 in das Gehäuse 20 abgeleitet, so dass die inneren Strukturen der Luftfahrzeugantriebsvorrichtung 10 vor Überspannungen geschützt sind.

Unterstützend hierzu sind auch die Drehwellenlager 14, 16 mit einer elektrischen Isolation 82 versehen.

Die Überleitung der Überspannung erfolgt durch einen Lichtbogen 84, der solange erhalten bleiben soll, bis die Blitzenergie möglichst weit abgeleitet ist.

Aus diesem Grunde ist die Überspannungsableitungseinrichtung 52 entweder bereits durch den stationären äußeren Ring 66 als Windabweiserelement 86 vor Fahrtwind oder durch den Propeller 22 erzeugtem Wind geschützt, oder es ist, wie in der weiteren Ausgestaltung der Fig. 4 dargestellt, ein gesondertes Windabweiserelement 86 zum Abweisen von Wind 88 vorgesehen.

Die Luftfahrzeugantriebsvorrichtung 10 kann zum Antrieb oder Vortrieb unterschiedlicher Luftfahrzeuge, wie Flugzeuge, Hubschrauber, Drehflügler, eingesetzt werden.

### Bezugszeichenliste:

- 10: Luftfahrzeugantriebsvorrichtung
- 10': Luftfahrzeugantriebsvorrichtung (nicht erfindungsgemäß)
- 12: Drehwelle
- 14: erstes Drehwellenlager
- 16: zweites Drehwellenlager
- 18: Drehwellenantriebsmaschine
- 20: Gehäuse
- 24: Faraday'schen Käfig
- 26: Gehäusepotential
- 28: Drehwellenpotential
- 30: elektrische Maschine
- 32: Elektromotor
- 34: Stator (aufgeschnitten dargestellt)
- 36: Rotor
- 38: stationäres Lagerelement
- 40: drehbares Lagerelement
- 42: Gehäuseöffnung
- 44: Innenraum des Gehäuses
- 46: Blitz
- 48: Stromverlauf
- 50: Überschlag
- 52: Überspannungsableitungseinrichtung
- 54: stationäres Elektrodenelement
- 56: drehendes Elektrodenelement
- 58: Ringelektroden
- 60: Elektrodenfläche
- 62: Spalt
- 64: Spaltabstand
- 66: stationärer äußerer Ring
- 68: stationärer innerer Ring
- 70: drehbarer Ring
- 72: felderhöhende Struktur
- 74: Spitze
- 78: Beschichtung
- 80: Umfangsoberfläche
- 82: elektrische Isolation
- 84: Lichtbogen
- 86: Windabweiserelement
- 88: Wind

## Patentansprüche

1. Luftfahrzeugantriebsvorrichtung (10) zum Erzeugen eines Vortriebs und/oder Auftriebs eines Luftfahrzeuges, umfassend eine Drehwelle (12), ein Drehwellenlager (14, 16), eine Drehwellenantriebsmaschine (18) zum drehenden Antreiben der Drehwelle (12) und ein Gehäuse (20), wobei das Drehwellenlager (14, 16) und die Drehwellenantriebsmaschine (18) in einen Innenraum des Gehäuses (44) angeordnet sind und die Drehwelle (12) durch eine Gehäuseöffnung (42) des Gehäuses (20) nach außerhalb des Gehäuses (20) ragt,
**dadurch gekennzeichnet,**
**dass** im Bereich der Gehäuseöffnung (42) eine Überspannungsableitungseinrichtung (52) angeordnet ist, die zum Ableiten einer auf der Drehwelle (12) anliegenden Überspannung ausgebildet ist,
**dass** die Überspannungsableitungseinrichtung (52) ein zum Ableiten einer Überspannung ausgebildetes stationäres Elektrodenelement (54) und ein auf Drehwellenpotential (28) liegendes drehbares Elektrodenelement (56) aufweist, wobei die Elektrodenelemente (54, 56) zur kontaktfreien Spannungsüberleitung von Überspannungen durch einen Spalt (62) beabstandet sind, und
1.1 dass wenigstens eines der Elektrodenelemente (54, 56) einen ersten Ring (66) und einen zweiten Ring (68) aufweist, zwischen denen das andere Elektrodenelement (54, 56) aufgenommen ist, und/oder
1.2 die Elektrodenelemente (54, 56) mit felderhöhenden Strukturen (72) mit Spitzen (74) aus leitfähigem Material versehen sind.

2. Luftfahrzeugantriebsvorrichtung (10) nach Anspruch 1, **dadurch gekennzeichnet**,
2.1 dass die Drehwellenantriebsmaschine (18) eine elektrische Maschine (30), insbesondere ein Elektromotor (32) mit Rotor (36) und Stator (34) ist und/oder
2.2 dass die Luftfahrzeugantriebsvorrichtung (10) einen elektrisch angetriebenen Propeller (22) aufweist.

3. Luftfahrzeugantriebsvorrichtung (10) nach einem der voranstehenden Ansprüche, **dadurch gekennzeichnet**,
3.1 dass ein Propeller (22) an dem aus dem Gehäuse (20) herausragenden Bereich der Drehwelle (12) angeordnet ist und/oder
3.2 dass ein erstes Drehwellenlager (14) und ein zweites Drehwellenlager (16) vorgesehen sind.

4. Luftfahrzeugantriebsvorrichtung nach einem der voranstehenden Ansprüche, **dadurch gekennzeichnet**,
4.1 dass das Gehäuse (20) zum Schaffen eines Blitzschutzes für die Drehwellenantriebsmaschine (18) selbst ausgebildet ist und/oder
4.2 dass das Gehäuse (20) einen Faraday'schen Käfig (24) schafft.

5. Luftfahrzeugantriebsvorrichtung nach einem der voranstehenden Ansprüche, **dadurch gekennzeichnet,**
**dass** zumindest ein Bereich der Drehwelle (12) auf einem elektrischen Drehwellenpotential (28) liegt und zumindest ein Bereich des Gehäuses (20) auf einem Gehäusepotential (26) liegt, wobei die Überspannungsableitungseinrichtung (52) zum Ableiten der Überspannung von dem Drehwellenpotential (28) auf das Gehäusepotential (26) ausgebildet ist.

6. Luftfahrzeugantriebsvorrichtung (10) nach einem der voranstehenden Ansprüche, **dadurch gekennzeichnet**,
6.1 dass wenigstens eine der Elektrodenelemente (54, 56) ringförmig ausgebildet ist und/oder
6.2 dass die Elektrodenelemente (54, 56) einander gegenüberliegende im Wesentlichen parallele Elektrodenflächen (60) aufweisen, zwischen denen der Spalt (62) gebildet ist.

7. Luftfahrzeugantriebsvorrichtung (10) nach einem der voranstehenden Ansprüche, **dadurch gekennzeichnet,**
**dass** wenigstens eines der Elektrodenelemente (54, 56) ein Lichtbogenzündelement zum Zünden eines Plasmakanals zwecks Überleitung der Überspannung aufweist.

8. Luftfahrzeugantriebsvorrichtung (10) nach einem der voranstehenden Ansprüche, **dadurch gekennzeichnet,**
**dass** wenigstens eines der Elektrodenelemente (54, 56) mit einer Beschichtung versehen ist, in der Spitzen (74) aus leitfähigen Partikeln und/oder polarisierenden Partikeln vorgesehen sind.

9. Luftfahrzeugantriebsvorrichtung (10) nach einem der voranstehenden Ansprüche, **dadurch gekennzeichnet**,
9.1 dass der Spalt (62) den kleinsten Abstand zwischen dem Drehwellenpotential (28) und dem Gehäusepotential (26) darstellt und/oder
9.2 dass der Spalt (62) einen Spaltabstand (64) im Bereich von 0, 1 µm bis 10 mm, vorzugsweise im Bereich von 0,01 mm bis 5 mm, hat.

10. Luftfahrzeugantriebsvorrichtung (10) nach einem der voranstehenden Ansprüche, **dadurch gekennzeichnet,**
**dass** das Drehwellenlager (14, 16) ein stationäres Lagerelement (38) und ein drehbares Lagerelement (40) und eine elektrische Isolation (82) zum elektrischen Isolieren des stationären Lagerelements (38) vom drehbaren Lagerelement (40) hat.

11. Luftfahrzeugantriebsvorrichtung (10) nach einem der voranstehenden Ansprüche,
**dadurch gekennzeichnet,**
**dass** zumindest ein Bereich der Drehwelle (12) und/oder des Gehäuses (20) mit einer Blitzschutzbeschichtung (78) versehen ist, die ausgewählt ist aus einer oder mehreren aus der Gruppe von Beschichtungen (78), die eine Beschichtung (78) mit einer elektrisch leitfähigen Schicht, eine Beschichtung (78) mit einem elektrisch leitfähigen Gitter, eine Beschichtung (78) mit elektrisch polarisierbaren Partikeln, eine Beschichtung (78) mit mit Spitzen (74) versehenen elektrisch leitfähigen Partikeln, eine Beschichtung (78) mit elektrisch polarisierbaren Partikeln in einer dielektrischen Matrix, eine Beschichtung (78) mit mit Spitzen (74) versehenen elektrisch leitfähigen Partikeln in einer dielektrischen Matrix und eine Beschichtung (78) mit Zündelementen zum Zünden eines Lichtbogens (84) aufweist.

12. Luftfahrzeugantriebsvorrichtung (10) nach einem der voranstehenden Ansprüche,
**dadurch gekennzeichnet,**
**dass** die Überspannungsableitungseinrichtung (52) ein Windabweiserelement (86) zum Schutz des Lichtbogens (84) aufweist.

13. Luftfahrzeugantriebsvorrichtung (10) nach einem der voranstehenden Ansprüche,
**dadurch gekennzeichnet,**
**dass** die Überspannungsableitungseinrichtung (52)
13.1 die Ableitung einer Überspannung zwischen der sich drehenden Drehwelle (12) und einem feststehenden Teil ermöglicht; und/oder
13.2 so ausgebildet ist, dass die Ableitung der Überspannung berührungslos durch einen Überschlag (50) und Lichtbogen (84) erfolgt.

14. Luftfahrzeugantriebsvorrichtung (10) nach einem der voranstehenden Ansprüche, **dadurch gekennzeichnet,**
**dass** die Überspannungsableitungseinrichtung (52)
14.1 eine feldüberhöhende Geometrie aufweist, so dass der Überschlag (50) an dieser dafür vorgesehenen Stelle bevorzugt erfolgt; und/oder
14.2 mit einer feldüberhöhenden Beschichtung (78) versehen ist, so dass der Überschlag (50) an dieser dafür vorgesehenen Stelle bevorzugt erfolgt.

15. Luftfahrzeug, umfassend eine Luftfahrzeugantriebsvorrichtung (10) nach einem der voranstehenden Ansprüche.

## Claims

1. Aircraft drive device (10) for producing propulsion and/or lift of an aircraft, comprising a rotary shaft (12), a rotary shaft bearing (14, 16), a rotary shaft drive machine (18) for rotationally driving the rotary shaft (12) and a housing (20), wherein the rotary shaft bearing (14, 16) and the rotary shaft drive machine (18) are arranged in an interior space of the housing (44) and the rotary shaft (12) protrudes outside of the housing (20) through a housing opening (42) of the housing (20), **characterized**
**in that** an overvoltage arrester device (52) is arranged in a region of the housing opening (42) and is designed to divert an overvoltage present at the rotary shaft (12),
**in that** the overvoltage arrester device (52) comprises a stationary electrode element (54) designed to divert an overvoltage and a rotatable electrode element (56) at a rotary shaft potential (28), wherein the electrode elements (54, 56) are spaced apart by a gap (62) for a contact-free voltage transfer of overvoltages, and
1.1 in that at least one of the electrode elements (54, 56) has a first ring (66) and a second ring (68), between which the other electrode element (54, 56) is accommodated, and/or
1.2 the electrode elements (54, 56) are provided with field-boosting structures (72) with spikes (74) of conductive material.

2. Aircraft drive device (10) according to Claim 1, characterized
2.1 in that the rotary shaft drive machine (18) is an electrical machine (30), in particular an electric motor (32) with a rotor (36) and a stator (34) and/or
2.2 in that the aircraft drive device (10) has an electrically driven propeller (22).

3. Aircraft drive device (10) according to one of the preceding claims, characterized
3.1 in that a propeller (22) is arranged on the region of the rotary shaft (12) protruding out of the housing (20) and/or
3.2 in that a first rotary shaft bearing (14) and a second rotary shaft bearing (16) are provided.

4. Aircraft drive device according to one of the preceding claims, characterized
4.1 in that the housing (20) is designed for providing lightning protection for the rotary shaft drive machine (18) itself and/or
4.2 in that the housing (20) provides a Faraday's cage (24) .

5. Aircraft drive device according to one of the preceding claims, **characterized**
**in that** at least a region of the rotary shaft (12) is at an electric rotary shaft potential (28) and at least a region of the housing (20) is at a housing potential (26), wherein the overvoltage arrester device (52) is designed to divert the overvoltage from the rotary shaft potential (28) to the housing potential (26).

6. Aircraft drive device (10) according to one of the preceding claims, characterized
6.1 in that at least one of the electrode elements (54, 56) is designed in the form of a ring and/or
6.2 in that the electrode elements (54, 56) have opposing substantially parallel electrode surfaces (60), between which the gap (62) is formed.

7. Aircraft drive device (10) according to one of the preceding claims, **characterized**
**in that** at least one of the electrode elements (54, 56) has an electric arc ignition element for igniting a plasma channel for the purpose of transferring the overvoltage.

8. Aircraft drive device (10) according to one of the preceding claims, **characterized**
**in that** at least one of the electrode elements (54, 56) is provided with a coating in which spikes (74) of conductive particles and/or polarizing particles are provided.

9. Aircraft drive device (10) according to one of the preceding claims, characterized
9.1 in that the gap (62) represents the smallest distance between the rotary shaft potential (28) and the housing potential (26) and/or
9.2 in that the gap (62) has a gap distance (64) in the range from 0.1 µm to 10 mm, preferably in the range from 0.01 mm to 5 mm.

10. Aircraft drive device (10) according to one of the preceding claims, **characterized**
**in that** the rotary shaft bearing (14, 16) has a stationary bearing element (38) and a rotatable bearing element (40) and an electrical insulation (82) for electrically insulating the stationary bearing element (38) from the rotatable bearing element (40).

11. Aircraft drive device (10) according to one of the preceding claims,
**characterized**
**in that** at least a region of the rotary shaft (12) and/or of the housing (20) is provided with a lightning protection coating (78), which is selected from one or more of the group of coatings (78) comprising a coating (78) with an electrically conductive layer, a coating (78) with an electrically conductive grid, a coating (78) with electrically polarizable particles, a coating (78) with electrically conductive particles provided with spikes (74), a coating (78) with electrically polarizable particles in a dielectric matrix, a coating (78) with electrically conductive particles provided with spikes (74) in a dielectric matrix, and a coating (78) with ignition elements for igniting an electric arc (84).

12. Aircraft drive device (10) according to one of the preceding claims,
**characterized**
**in that** the overvoltage arrester device (52) has a wind deflector device (86) for protecting the electric arc (84) .

13. Aircraft drive device (10) according to one of the preceding claims,
**characterized**
**in that** the overvoltage arrester device (52)
13.1 allows the diversion of an overvoltage between the rotating rotary shaft (12) and a stationary part; and/or
13.2 is designed in such a way that the diversion of the overvoltage takes place in a contactless manner by a flashover (50) and an electric arc (84).

14. Aircraft drive device (10) according to one of the preceding claims, **characterized**
**in that** the overvoltage arrester device (52)
14.1 has a field-boosting geometry, so that the flashover (50) preferably takes place at this location provided for it; and/or
14.2 is provided with a field-boosting coating (78), so that the flashover (50) preferably takes place at this location provided for it.

15. Aircraft, comprising an aircraft drive device (10) according to one of the preceding claims.

## Revendications

1. Dispositif d'entraînement d'un aéronef (10) pour la production d'une propulsion et/ou d'une portance d'un aéronef, comprenant un arbre rotatif (12), un palier d'arbre rotatif (14, 16), une machine d'entraînement de l'arbre rotatif (18) pour l'entraînement rotatif de l'arbre rotatif (12) et un boîtier (20), dans lequel le palier d'arbre rotatif (14, 16) et la machine d'entraînement de l'arbre rotatif (18) sont disposés dans un espace intérieur (44) du boîtier et l'arbre rotatif (12) s'étend à travers une ouverture de boîtier (42) du boîtier (20) vers l'extérieur du boîtier (20), **caractérisé en ce que**
un dispositif d'élimination de surtension (52) est disposé dans la région de l'ouverture de boîtier (42), lequel est configuré de façon à éliminer une surtension appliquée à l'arbre rotatif (12),
le dispositif d'élimination de surtension (52) présente un élément d'électrode stationnaire (54) réalisé pour éliminer une surtension et un élément d'électrode rotatif (56) se trouvant au potentiel de l'arbre rotatif (28), dans lequel les éléments d'électrode (54, 56) sont espacés par une fente (62) pour la transmission de tension sans contact de surtensions, et **en ce que**
1.1 au moins un des éléments d'électrode (54, 56) présente un premier anneau (66) et un second anneau (68), entre lesquels l'autre élément d'électrode (54, 56) est placé, et/ou
1.2 les éléments d'électrode (54, 56) sont dotés de structures (72) avec des pointes (74) en matériau conducteur pour augmenter les champs.

2. Dispositif d'entraînement d'aéronef (10) selon la revendication 1, **caractérisé en ce que**
2.1 la machine d'entraînement de l'arbre rotatif (18) est une machine électrique (30), en particulier un moteur électrique (32) avec un rotor (36) et un stator (34), et/ou
2.2 le dispositif d'entraînement d'aéronef (10) présente une hélice (22) entraînée électriquement.

3. Dispositif d'entraînement d'aéronef (10) selon l'une quelconque des revendications précédentes, **caractérisé en ce que**
3.1 une hélice (22) est disposée sur la région de l'arbre rotatif (12) sortant hors du boîtier (20), et/ou
3.2 il est prévu un premier palier d'arbre rotatif (14) et un second palier d'arbre rotatif (16).

4. Dispositif d'entraînement d'aéronef selon l'une quelconque des revendications précédentes, **caractérisé en ce que**
4.1 le boîtier (20) est réalisé de façon à procurer une protection contre la foudre pour la machine d'entraînement de l'arbre rotatif (18) elle-même, et/ou
4.2 le boîtier (20) procure une cage de Faraday (24).

5. Dispositif d'entraînement d'aéronef selon l'une quelconque des revendications précédentes, **caractérisé en ce qu'**au moins une région de l'arbre rotatif (12) se trouve à un potentiel électrique d'arbre rotatif (28) et au moins une région du boîtier (20) se trouve à un potentiel de boîtier (26), dans lequel le dispositif d'élimination de surtension (52) est réalisé pour éliminer la surtension du potentiel d'arbre rotatif (28) au potentiel de boîtier (26).

6. Dispositif d'entraînement d'aéronef (10) selon l'une quelconque des revendications précédentes, **caractérisé en ce que**
6.1 au moins un des éléments d'électrode (54, 56) est réalisé sous forme annulaire, et/ou
6.2 les éléments d'électrode (54, 56) présentent des faces d'électrode essentiellement parallèles (60) opposées l'une à l'autre, entre lesquelles la fente (62) est formée.

7. Dispositif d'entraînement d'aéronef (10) selon l'une quelconque des revendications précédentes, **caractérisé en ce qu'**au moins un des éléments d'électrode (54, 56) présente un élément d'allumage d'arc pour amorcer un canal de plasma en vue de transmettre la surtension.

8. Dispositif d'entraînement d'aéronef (10) selon l'une quelconque des revendications précédentes, **caractérisé en ce qu'**au moins un des éléments d'électrode (54, 56) est muni d'un revêtement, dans lequel il est prévu des pointes (74) en particules conductrices et/ou en particules polarisantes.

9. Dispositif d'entraînement d'aéronef (10) selon l'une quelconque des revendications précédentes, **caractérisé en ce que**
9.1 la fente (62) représente la plus petite distance entre le potentiel d'arbre rotatif (28) et le potentiel de boîtier (26) et/ou
9.2 la fente (62) a une distance de fente (64) comprise dans la plage de 0,1 µm à 10 mm, de préférence dans la plage de 0,01 mm à 5 mm.

10. Dispositif d'entraînement d'aéronef (10) selon l'une quelconque des revendications précédentes, **caractérisé en ce que** le palier d'arbre rotatif (14, 16) comprend un élément de palier stationnaire (38) et un élément de palier rotatif (40) et une isolation électrique (82) pour l'isolation électrique de l'élément de palier stationnaire (38) par rapport à l'élément de palier rotatif (40).

11. Dispositif d'entraînement d'aéronef (10) selon l'une quelconque des revendications précédentes, **caractérisé en ce qu'**au moins une région de l'arbre rotatif (12) et/ou du boîtier (20) est munie d'un revêtement de protection contre la foudre (78), qui est sélectionné parmi un ou plusieurs revêtement(s) dans le groupe de revêtements (78), qui présente un revêtement (78) avec une couche électriquement conductrice, un revêtement (78) avec une grille électriquement conductrice, un revêtement (78) avec des particules électriquement polarisables, un revêtement (78) avec des particules électriquement conductrices dotées de pointes (74), un revêtement (78) avec des particules électriquement polarisables dans une matrice diélectrique, un revêtement (78) avec des particules électriquement conductrices dotées de pointes (74) dans une matrice diélectrique et un revêtement (78) avec des éléments d'allumage pour amorcer un arc électrique (84).

12. Dispositif d'entraînement d'aéronef (10) selon l'une quelconque des revendications précédentes, **caractérisé en ce que** le dispositif d'élimination de surtension (52) présente un élément de déflecteur (86) pour la protection de l'arc électrique (84).

13. Dispositif d'entraînement d'aéronef (10) selon l'une quelconque des revendications précédentes, **caractérisé en ce que** le dispositif d'élimination de surtension (52)
13.1 permet l'élimination d'une surtension entre l'arbre rotatif tournant (12) et une partie stationnaire; et/ou
13.2 est configuré de telle manière que l'élimination de la surtension se fasse sans contact par un claquage (50) et un arc électrique (84).

14. Dispositif d'entraînement d'aéronef (10) selon l'une quelconque des revendications précédentes, **caractérisé en ce que** le dispositif d'élimination de surtension (52)
14.1 présente une géométrie d'augmentation de champ, de telle manière que le claquage (50) se produise de préférence à cet endroit prévu à cet effet; et/ou
14.2 est muni d'un revêtement d'augmentation de champ (78), de telle manière que le claquage (50) se produise de préférence à cet endroit prévu à cet effet.

15. Aéronef, comprenant un dispositif d'entraînement d'aéronef (10) selon l'une quelconque des revendications précédentes.
